# EUROPEAN PATENT SPECIFICATION

(11) **EP 1 652 292 B1**
(45) Date of publication and mention of the grant of the patent: **15.10.2008**
(21) Application number: 03817621.0
(22) Date of filing: 25.07.2003
(51) Int. Cl.: H03D 7/14

(54) **OFFSET CORRECTION FOR DOWN-CONVERSION MIXERS**
OFFSETKORREKTUR FÜR ABWÄRTSUMSETZUNGSMISCHER
CORRECTION DE DECALAGE POUR MELANGEURS ABAISSEURS DE FREQUENCE

(43) Date of publication of application: 03.05.2006
(73) Proprietor: NXP B.V., 5656 AG Eindhoven (NL)
(72) Inventor: REDMAN-WHITE, William, San Jose, CA 95131 (US)
(74) Representative: van der Veer, Johannis Leendert
(86) International application number: PCT/IB2003/003362
(87) International publication number: WO 2005/011103

(56) References cited:
- EP-A- 1 193 863
- WO-A-02/084859
- US-A- 5 933 771
- US-A1- 2002 097 081

## Description

This invention relates to the field of communications, and in particular to a switching and bias correction system for direct conversion receivers.

Direct conversion receivers are commonly used in wireless communication devices, such as cellular telephones. A particular concern in the design of such devices is the interference that each device may cause to each other device in a local environment. For example, in a direct conversion receiver, wherein a local oscillator (LO) signal is mixed directly with the received radio-frequency (RF) signal, leakage from the local oscillator is easily communicated to the RF antenna, and can interfere with other signals in the vicinity of the antenna.

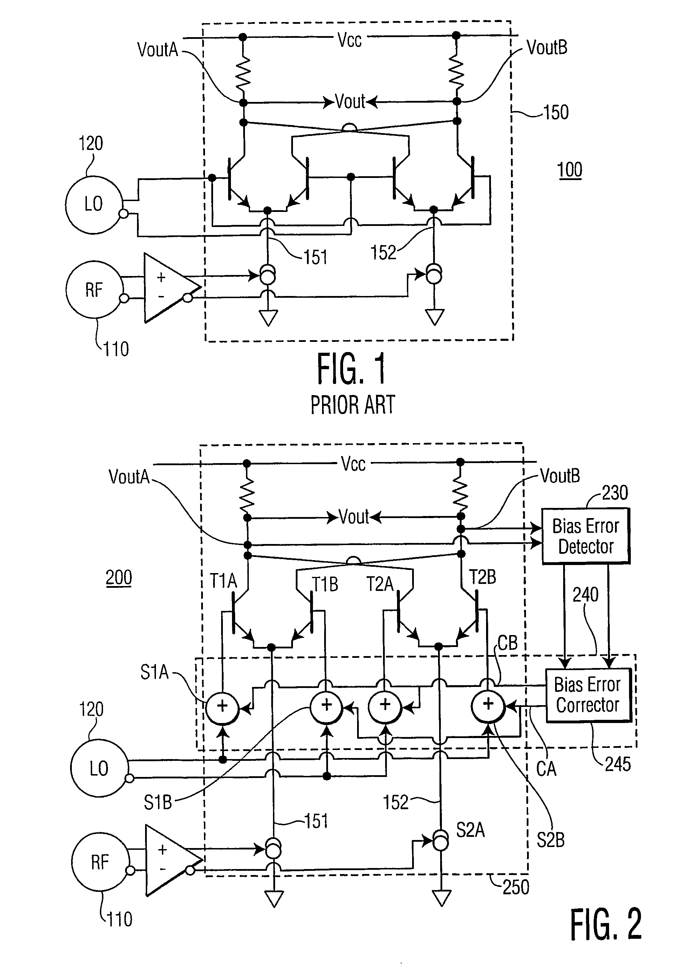

FIG. 1 illustrates an example schematic of a prior art direct conversion receiver system 100. As illustrated, a mixer 150 demodulates an RF signal 110 via a local oscillator 120 to produce a baseband output Vout. Ideally, if the complementary outputs of the local oscillator 120 are true inversions of each other, if the transistors and load resistors are matched, and if the input transconductance is ideally balanced, there will be no leakage of the local oscillator 120 into the RF signal 110. To minimize noise sensitivity and to further minimize the propagation of the local oscillator signal 120 to the RF signal 110, differential circuits are used throughout, thereby cancelling the common-mode leakage or noise.

If the complementary outputs, or phases, of the local oscillator 120 are not truly complementary of each other, the switching points of the transistors in the mixer 150 will differ, and a difference signal at the local oscillator frequency will be created. Although this difference signal is a common-mode signal, an imbalance of the input transconductance at the tail nodes 151, 152 will transform this common-mode signal to a differential-mode signal, which will be propagated back to the RF signal 110, and possibly emanated from the RF antenna at the local oscillator frequency.

Even with true complementary outputs of the local oscillator 120, random mismatches of component values within the mixer 150 may affect the DC offset of one or more of the transistors, such that the crossover points in the individual transistor pairs is offset from the instant where the complementary outputs of the local oscillator 120 cross. Such an offset will produce a mark:space ratio that is no longer 1:1, and the signals at the tail nodes 151, 152 will not be matched. This mismatch will produce a differential-mode signal at the local oscillator frequency that is propagated to the RF signal 110, and possibly emanated from the RF antenna, regardless of the balance of the input transconductance at the tail nodes 151, 152.

US-A-2002/0097081 describes a circuit in which a transconductance amplifier having a programmable gain is coupled to the output of a mixer in a feedback loop for reducing DC offset.

It is an object of this invention to reduce the amount of leakage in a local oscillator of a direct conversion receiver. It is a further object of this invention to transform residual leakage in the local oscillator to common-mode leakage.

These and other objects of the invention are achieved by a direct conversion receiver that includes a detector that provides a measure of bias offset that is caused by component mismatches in the direct conversion mixer, and a corrective network that reduces the bias offset based on this measure. The direct conversion mixer demodulates a radio-frequency (RF) input signal via mixing with a local-oscillator (LO) signal to provide a differential baseband output signal. A differential peak detector compares the peak signal value at each side of the mixer's differential output, and a differential integrator averages the difference between these peak signal values to provide the measure of bias offset. The corrective network adds a correction offset to each of the local oscillator local oscillator paths on each of the switching pairs that provide the differential output, but opposite to the local oscillator connections. By applying the correction offset to the opposing transistor in each pair, the difference in switching time between the pairs is reduced, and, correspondingly, the differential-mode leakage from the local oscillator to the RF input stage is reduced.

The invention is explained in further detail, and by way of example, with reference to the accompanying drawings wherein:
Fig. 1 illustrates an example schematic of a prior art direct conversion receiver.
Fig. 2 illustrates an example schematic of a direct conversion receiver with bias-offset correction in accordance with this invention.
Fig. 3 illustrates an example schematic of a bias error detector and corrective network in accordance with this invention.

Throughout the drawings, the same reference numerals indicate similar or corresponding features or functions.

Fig. 2 illustrates an example schematic of a direct conversion receiver 200 with bias-offset correction in accordance with this invention. The receiver 200 includes a mixer 250, corresponding to the mixer 150 of the prior art Fig. 1, with the addition of a corrective network 240 that adjusts the bias levels of the mixing transistors T1A, T1B, T2A, and T2B to minimize the effects of component variations in the mixer 250.

In an ideal embodiment of a differential direct conversion receiver such as illustrated in FIG. 1, the input RF signal is alternately mixed with symmetric half-cycles of the local oscillator, each half cycle being processed by alternate transistors in each differential branch of the mixer. Because of the symmetric structure and processing in the ideal mixer, each side, or phase, VoutA and VoutB, of the differential voltage output Vout will exhibit equal and opposite signal excursions about a common DC level. Component variations in the mixer that affect the bias of the transistors will shift the crossover points in the individual transistor pairs, and cause an imbalance within the transistor pair and/or between the transistor pairs. For ease of reference, the term imbalance is used hereinafter to refer to responses that differ from the symmetric responses of an ideal mixer.

This invention is premised on the observation that imbalances caused by component variations in a mixer cause an imbalance between the phases of the differential output of a direct conversion mixer, and a measure of the imbalance at the differential output can be used to correct the mixer for such imbalances.

As illustrated in FIG. 2, a bias-error detector 230 detects the imbalance within the opposing phases VoutA and VoutB of the differential output Vout. The detected imbalance is provided to a bias error corrector 245 in the corrective network 240, to provide correction signals CA and CB for adjusting the bias of each of the transistors T1A, T1B, T2A, and T2B.

The correction signals CA and CB are directly correlated to the imbalance of VoutA and VoutB, respectively. As illustrated, the correction signals CA, CB are applied in opposition to the local oscillator 120. That is, correction signal CA is applied to transistors T1B and T2B, to affect VoutB, and correction signal CB is applied to transistors T1A and T2A, to affect VoutA. By applying the correction in opposition to the local oscillator 120, the difference in switching time between the pairs T1A-T1B and T2A-T2B is reduced, and, correspondingly, the differential-mode leakage from the local oscillator to the RF input stage is reduced.

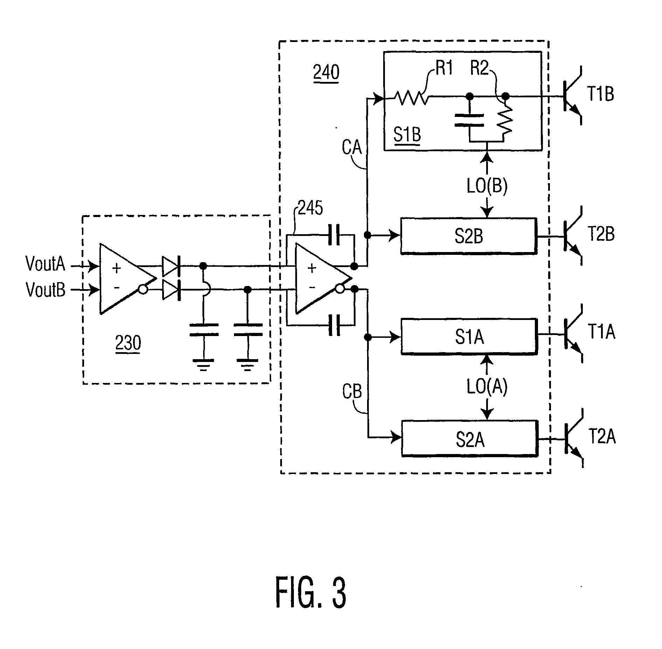

FIG. 3 illustrates an example schematic of a bias error detector 230 and corrective network 240 in accordance with this invention, although other techniques for detecting an imbalance within and between each phase of a differential output pair, VoutA and VoutB, and for providing a correction signal CA, CB to the mixer 250 to compensate for the imbalance will be evident to one of ordinary skill in the art in view of this disclosure.

The example bias error detector 230 comprises a differential amplifier, to eliminate the common DC potential of the differential output pair, followed by a pair of rectifier-capacitors, to form a peak-detector pair for measuring the peak excursion of each phase of the differential output pair relative to the common DC potential. In an ideal mixer, the peak excursions of VoutA and VoutB about the common DC potential will be equal; in a non-ideal mixer, component variations will cause the peak values to differ. The corrective network 240 includes a differential integrator 245 that averages the differences between the peak values to produce the correction values CA, CB. The summing devices S1A, S1B, S2A, and S2B add the correction values CB, CA to the opposing local oscillator signals LO(A), LO(B) to adjust the bias of the corresponding transistors T1A, T1B, S2A, and S2B, respectively.

FIG. 3 also illustrates an example summing device S1B. The correction signal is applied via a large resistor R1, relative to a smaller resistor R2 in the local oscillator path. In this manner, the resistor R2 sets the common-mode bias, while the resistor R1 modifies the bias based on the unbalance between the phases of the differential output Vout. To facilitate effective AC-coupling, the local oscillator is also capacitively coupled to the mixing transistor.

The foregoing merely illustrates the principles of the invention. It will thus be appreciated that those skilled in the art will be able to devise various arrangements which, although not explicitly described or shown herein, embody the principles of the invention and are thus within the scope of the following claims.

## Claims

1. A direct conversion receiver (200) comprising:
- a double balanced mixer (250) for mixing a differential local oscillator signal with a differential radio frequency signal for providing a differential output signal, the double balanced mixer comprising four transistors (T1A, T1B, T2A, T2B) arranged into first pair and second pair, emmiter terminals of said transistors being coupled to the radio frequency signal,
- a bias error detector (230) coupled to the double balanced mixer for receiving the differential output signal, the bias error detector producing a measure of imbalance of the differential output signal, and
- a corrective network (240), operably coupled to the bias error detector (230) and the mixer (250), that is configured to apply a differential corrective signal to the mixer (250) to reduce the imbalance said corrective network comprising four summing devices (S1A, S1B, S2A, S2B) which are coupled for adding said differential corrective signal to the local oscillator signal and to adjust a bias of said transistors (T1A, T1B, T2A, T2B).

2. The direct conversion receiver (200) of claim 1, wherein the bias error detector (230) includes a differential peak detector that is configured to detect peak signal values corresponding to each phase of the differential output signal, the measure of imbalance being dependent upon a difference between the peak signal values.

3. The direct conversion receiver (200) of claim 2, wherein the corrective network (240) includes a differential integrator (245) that is configured to average the peak signal values corresponding to each phase of the differential output signal to produce the differential corrective signal.

4. The direct conversion receiver (200) of claim 1, wherein the corrective network (240) includes a differential integrator (245) that is configured to average the measure of imbalance of the differential output signal.

5. A direct conversion receiver as claimed in claim 1, wherein the first transistor pair (T1A, T1B) includes:
- a first transistor (T1A) having: a base that receives a first bias input that is dependent upon a first phase of the local-oscillator signal and a first correction signal, a collector that is coupled to a first phase of the baseband output signal, and an emitter that is coupled to a first phase of the radio-frequency signal;
- a second transistor (T1B) having: a base that receives a second bias input that is dependent upon a second phase of the local-oscillator signal and a second correction signal, and a collector that is coupled to a second phase of the baseband output signal, and an emitter that is coupled to the first phase of the radio-frequency signal; and the second transistor pair (T2A, T2B) includes:
- a third transistor (T2A) having: a base that receives a third bias input that is dependent upon the second phase of the local-oscillator signal and the first correction signal, a collector that is coupled to the first phase of the baseband output signal, and an emitter that is coupled to a second phase of the radio-frequency signal;
- a fourth transistor (T2B) having: a base that receives a fourth bias input that is dependent upon the first phase of the local-oscillator signal and the first correction signal, a collector that is coupled to the second phase of the baseband output signal, and an emitter that is coupled to the second phase of the radio-frequency signal;
wherein:
- the second correction signal is based a first measure of imbalance corresponding to the first phase of the baseband output signal, and the first correction signal is based on a second measure of imbalance corresponding to the second phase of the baseband output signal.

6. A direct conversion receiver as claimed in claim 5, wherein the mixer (250) further comprising:
- a first current generator that controls current through the emitters of the first and second transistors, based on the first phase of the radio-frequency signal; and
- a second current generator that controls current through the emitters of the third and fourth transistors, based on the second phase of the radio-frequency signal.

7. A direct conversion receiver as claimed in claim 5, wherein the mixer (250) further comprise a differential peak detector (230) that is configured to provide: a first peak signal corresponding to a peak excursion of the first phase of the baseband output signal, and a second peak signal corresponding to a peak excursion of the second phase of the baseband output signal, wherein the first measure of imbalance is based on the first peak signal, and the second measure of imbalance is based on the second peak signal.

8. A direct conversion receiver as claimed in claim 7, wherein the mixer (250), further comprise an integrator (245) that is configured to provide the first measure of imbalance corresponding to an average of the first peak signal, the second measure of imbalance corresponding to an average of the second peak signal.

9. A method of reducing leakage from a double balanced mixer (250) for combining a differential local oscillator signal with a differential radio frequency signal for providing a differential output signal comprising steps of:
- measuring (230) a degree of imbalance associated with the differential output signal of the double balanced mixer (250), and adjusting (240) a bias points of four switching devices (T1A, T1B, T2A, T2B) in the double balanced mixer (250) by adding a corrective signal to the local oscillator via a summing device (S1A, S1B, S2A, S2B) based on the degree of imbalance.

10. The method of claim 9, wherein the differential output signal of the double balanced mixer (250) has a first phase and a second phase, and measuring (230) the degree of imbalance includes: measuring an imbalance associated with the first phase, and measuring an imbalance associated with the second phase.

11. The method of claim 10, wherein adjusting (240) the bias point includes adjusting a bias point of one or more first switching devices (T1A, T2A) that control the first phase, based on the imbalance associated with the second phase, and adjusting a bias point of one or more second switching devices (T1B, T2B) that control the second phase, based on the imbalance associated with the first phase.

12. The method of claim 10, wherein measuring (230) the imbalance associated with the first phase and the second phase includes measuring peak excursions of the first phase and the second phase.

13. The method of claim 9, wherein measuring (230) the degree of imbalance includes measuring a peak excursion of the output signal.

## Patentansprüche

1. Ein Direktumsetzungsempfänger (200), umfassend:
einen Ringmischer (250) zum Mischen eines Differenzsignals eines Überlagerungsoszillators mit einem Hochfrequenz-Differenzsignal zum Bereitstellen eines Differenzausgangssignals, wobei der Ringmischer vier Transistoren (T1A, T1B, T2A, T2B) umfasst, die in einem ersten Paar und einem zweiten Paar angeordnet sind, wobei Emitteranschlüsse der Transistoren mit dem Hochfrequenzsignal verbunden sind,
einen Detektor zum Feststellen des systematischen Fehlers (230), der mit dem Ringmischer verbunden ist, zum Empfangen des Differenzausgangssignals, wobei der Detektor zum Feststellen des systematischen Fehlers ein Maß der Instabilität des Differenzausgangssignals erzeugt, und
eine Ausgleichsschaltung (240), die betriebsfähig mit dem Detektor zum Feststellen des systematischen Fehlers (230) und dem Mischer (250) verbunden ist, die so konfiguriert ist, dass sie an den Mischer (250) ein Differenzausgleichssignal anlegt, um die Instabilität zu vermindern, wobei die Ausgleichsschaltung vier Summiervorrichtungen (S1A, S1B, S2A, S2B) umfasst, die so geschaltet sind, dass sie das Differenzausgleichssignal zum Überlagerungsoszillatorsignal addieren und eine Vorspannung der Transistoren (T1A, T1B, T2A, T2B) einstellen.

2. Der Direktumsetzungsempfänger (200) nach Anspruch 1, wobei der Detektor zum Feststellen des systematischen Fehlers (230) einen Detektor zum Feststellen des Differenzspitzenwerts einschließt, der so konfiguriert ist, dass er Signalspitzenwerte feststellt, die jeder Phase des Differenzausgangssignals entsprechen, wobei das Maß der Instabilität von einer Differenz zwischen den Signalspitzenwerten abhängt.

3. Der Direktumsetzungsempfänger (200) nach Anspruch 2, wobei die Ausgleichsschaltung (240) einen Differenzintegrator (245) einschließt, der so konfiguriert ist, dass er die Signalspitzenwerte, die jeder Phase des Differenzausgangssignals entsprechen, mittelt, um das Differenzausgleichssignal zu erzeugen.

4. Der Direktumsetzungsempfänger (200) nach Anspruch 1, wobei die Ausgleichsschaltung (240) einen Differenzintegrator (245) einschließt, der so konfiguriert ist, dass er das Maß der Instabilität des Differenzausgangssignals mittelt.

5. Ein Direktumsetzungsempfänger nach Anspruch 1, wobei das erste Transistorpaar (T1A, T1B) einschließt:
- einen ersten Transistor (T1A) mit einer Basis, die eine erste Vorspannungseingangsleistung empfängt, die von einer ersten Phase des Überlagerungsoszillatorsignals und einem ersten Korrektursignal abhängt, einem Kollektor, der mit einer ersten Phase des Basisband-Ausgangssignals verbunden ist, und einem Emitter, der mit einer ersten Phase des Hochfrequenzsignals verbunden ist,
- einen zweiten Transistor (T1B) mit einer Basis, die eine zweite Vorspannungseingangsleistung empfängt, die von einer zweiten Phase des Überlagerungsoszillatorsignals und einem zweiten Korrektursignal abhängt, und einem Kollektor, der mit einer zweiten Phase des Basisband-Ausgangssignals verbunden ist, und einem Emitter, der mit der ersten Phase des Hochfrequenzsignals verbunden ist, und
das zweite Transistorpaar (T2A, T2B) einschließt:
- einen dritten Transistor (T2A) mit einer Basis, die eine dritte Vorspannungseingangsleistung empfängt, die von der zweiten Phase des Überlagerungsoszillatorsignals und dem ersten Korrektursignal abhängt, einem Kollektor, der mit der ersten Phase des Basisband-Ausgangssignals verbunden ist, und einem Emitter, der mit einer zweiten Phase des Hochfrequenzsignals verbunden ist,
- einen vierten Transistor (T2B) mit einer Basis, die eine vierte Vorspannungseingangsleistung empfängt, die von der ersten Phase des Überlagerungsoszillatorsignals und dem ersten Korrektursignal abhängt, einem Kollektor, der mit der zweiten Phase des Basisband-Ausgangssignals verbunden ist, und einem Emitter, der mit der zweiten Phase des Hochfrequenzsignals verbunden ist,
wobei
- das zweite Korrektursignal auf einem ersten Maß der Instabilität basiert, das der ersten Phase des Basisband-Ausgangssignals entspricht, und das erste Korrektursignal auf einem zweiten Maß der Instabilität basiert, das der zweiten Phase des Basisband-Ausgangssignals entspricht.

6. Ein Direktumsetzungsempfänger nach Anspruch 5, wobei der Mischer (250) ferner umfasst:
- einen ersten Stromerzeuger, der den Strom durch die Emitter des ersten und zweiten Transistors basierend auf der erste Phase des Hochfrequenzsignals regelt, und
- einen zweiten Stromerzeuger, der den Strom durch die Emitter des dritten und vierten Transistors basierend auf der zweiten Phase des Hochfrequenzsignals regelt.

7. Ein Direktumsetzungsempfänger nach Anspruch 5, wobei der Mischer (250) ferner einen Detektor zum Feststellen des Differenzspitzenwerts (230) umfasst, der so konfiguriert ist, dass er bereitstellt: ein erstes Spitzensignal, das einem Spitzenausschlag der ersten Phase des Basisband-Ausgangssignals entspricht, und ein zweites Spitzensignal, das einem Spitzenausschlag der zweiten Phase des Basisband-Ausgangssignals, entspricht, wobei das erste Maß der Instabilität auf dem ersten Spitzensignal basiert und das zweite Maß der Instabilität auf dem zweiten Spitzensignal basiert.

8. Ein Direktumsetzungsempfänger nach Anspruch 7, wobei der Mischer (250) ferner einen Integrator (245) umfasst, der so konfiguriert ist, dass er bereitstellt: das erste Maß der Instabilität, das einem Mittelwert des ersten Spitzensignals entspricht, das zweite Maß der Instabilität, das einem Mittelwert des zweiten Spitzensignals entspricht.

9. Ein Verfahren zum Vermindern von Leckverlusten aus einem Ringmischer (250) zum Kombinieren eines Differenzsignals eines Überlagerungsoszillators mit einem Hochfrequenz-Differenzsignal zum Bereitstellen eines Differenzausgangssignals, das folgende Schritte umfasst:
- Messen (230) eines Grads der Instabilität, der dem Differenzausgangssignal des Ringmischers (250) zugeordnet ist, und Einstellen (240) von Arbeitspunkten von vier Schaltvorrichtungen (T1A, T1B, T2A, T2B) in dem Ringmischer (250) durch Addieren eines Ausgleichssignals zu dem Überlagerungsoszillator mittels einer Summiervorrichtung (S1A, S1B, S2A, S2B) basierend auf dem Grad der Instabilität.

10. Das Verfahren nach Anspruch 9, wobei das Differenzausgangssignal des Ringmischers (250) eine erste Phase und eine zweite Phase aufweist und das Messen (230) des Grads der Instabilität einschließt: Messen einer Instabilität, die der ersten Phase zugeordnet ist, und Messen einer Instabilität, die der zweiten Phase zugeordnet ist.

11. Das Verfahren nach Anspruch 10, wobei das Einstellen (240) des Arbeitspunkts einschließt: Einstellen eines Arbeitspunkts einer ersten oder mehrerer erster Schaltvorrichtung(en) (T1A, T1B), welche die erste Phase regeln, basierend auf der Instabilität, die der zweiten Phase zugeordnet ist, und Einstellen eines Arbeitspunkt einer zweiten oder mehrerer zweiter Schaltvorrichtung(en) (T1B, T2B), welche die zweite Phase regeln, basierend auf der Instabilität, die der ersten Phase zugeordnet ist.

12. Das Verfahren nach Anspruch 10, wobei das Messen (230) der Instabilität, die der ersten Phase und der zweiten Phase zugeordnet ist, das Messen von Spitzenausschlägen der ersten Phase und der zweiten Phase einschließt.

13. Das Verfahren nach Anspruch 9 wobei das Messen (230) des Grads der Instabilität das Messen eines Spitzenausschlags des Ausgangssignals einschließt.

## Revendications

1. Récepteur à conversion directe (200), comprenant :
- un mélangeur équilibré double (250) pour mélanger un signal d'oscillateur local différentiel avec un signal radiofréquence différentiel pour générer un signal de sortie différentiel, le mélangeur équilibré double comportant quatre transistors (T1A, T1B, T2A, T2B) agencés en une première paire et une deuxième paire, les broches d'émetteur desdits transistors étant raccordées au signal radiofréquence,
- un détecteur d'erreur de polarisation (230) raccordé au mélangeur équilibré double pour recevoir le signal de sortie différentiel, le détecteur d'erreur de polarisation générant une mesure du déséquilibre du signal de sortie différentiel, et
- un réseau de correction (240), couplé de manière opérationnelle au détecteur d'erreur de polarisation (230) et au mélangeur (250), qui est configuré pour appliquer un signal de correction différentiel au mélangeur (250) pour réduire le déséquilibre, ledit réseau de correction comportant quatre dispositifs de sommation (S1A, S1B, S2A, S2B) qui sont raccordés pour ajouter ledit signal de correction différentiel au signal de l'oscillateur local et régler une polarisation desdits transistors (T1A, T1B, T2A, T2B).

2. Récepteur à conversion directe (200) selon la revendication 1, dans lequel le détecteur d'erreur de polarisation (230) contient un détecteur de crête différentiel qui est configuré pour détecter les valeurs crête du signal correspondant à chacune des phases du signal de sortie différentiel, la mesure du déséquilibre étant fonction de la différence entre les valeurs crête du signal.

3. Récepteur à conversion directe (200) selon la revendication 2, dans lequel le réseau de correction (240) contient un intégrateur différentiel (245) qui est configuré pour faire la moyenne des valeurs crête du signal correspondant à chacune des phases du signal de sortie différentiel pour générer le signal de correction différentiel.

4. Récepteur à conversion directe (200) selon la revendication 1, dans lequel le réseau de correction (240) comprend un intégrateur différentiel (245) qui est configuré pour faire la moyenne de la mesure du déséquilibre du signal de sortie différentiel.

5. Récepteur à conversion directe selon la revendication 1, dans lequel la première paire de transistor (T1A, T1B) contient ;
- un premier transistor (T1A) ayant : une base qui reçoit une première entrée de polarisation qui est dépendante d'une première phase du signal d'oscillateur local et d'un premier signal de correction, un collecteur qui est raccordé à une première phase du signal de sortie en bande de base, et un émetteur qui est raccordé à une première phase du signal radiofréquence ;
- un deuxième transistor (T1B) ayant : une base qui reçoit une deuxième entrée de polarisation qui est dépendante d'une deuxième phase du signal d'oscillateur local et d'un deuxième signal de correction, un collecteur qui est raccordé à une deuxième phase du signal de sortie en bande de base et un émetteur qui est raccordé à la première phase du signal radiofréquence ; et la deuxième paire de transistor (T2A, T2B) contient ;
- un troisième transistor (T2A) ayant : une base qui reçoit une troisième entrée de polarisation qui est dépendante de la deuxième phase du signal d'oscillateur local et du premier signal de correction, un collecteur qui est raccordé à la première phase du signal de sortie en bande de base et un émetteur qui est raccordé à une deuxième phase du signal radiofréquence ;
- un quatrième transistor (T2B) ayant : une base qui reçoit une quatrième entrée de polarisation qui est dépendante de la première phase du signal d'oscillateur local et du premier signal de correction, un collecteur qui est raccordé à la deuxième phase du signal de sortie en bande de base et un émetteur qui est raccordé à la deuxième phase du signal radiofréquence ;¹
¹ NdT. La définition du troisième et du quatrième transistor n'est pas équilibrée pour ce qui concerne le signal de correction. L'un des deux devrait être le « deuxième signal de correction » au lieu du « premier signal de correction ».
dans lequel :
- le deuxième signal de correction est fondé sur une première mesure du déséquilibre correspondant à la première phase du signal de sortie en bande de base et le premier signal de correction est fondé sur une deuxième mesure du déséquilibre correspondant à la deuxième phase du signal de sortie en bande de base.

6. Récepteur à conversion directe selon la revendication 5, dans lequel le mélangeur (250) contient en outre :
- un premier générateur de courant qui commande le courant à travers les émetteurs du premier et du deuxième transistor, fondé sur la première phase du signal radiofréquence ; et
- un deuxième générateur de courant qui commande le courant à travers les émetteurs du troisième et du quatrième transistor, fondé sur la deuxième phase du signal radiofréquence.

7. Récepteur à conversion directe selon la revendication 5, dans lequel le mélangeur (250) comprend en outre un détecteur de crête différentiel (230) qui est configuré pour générer : un premier signal de crête correspondant à une excursion de crête de la première phase du signal de sortie en bande de base, et un deuxième signal de crête correspondant à une excursion de crête de la deuxième phase du signal de sortie en bande de base, dans lequel la première mesure du déséquilibre est fondée sur le premier signal crête et la deuxième mesure du déséquilibre est fondée sur le deuxième signal crête.

8. Récepteur à conversion directe selon la revendication 7, dans lequel le mélangeur (250) comprend en outre un intégrateur (245) qui est configuré pour générer la première mesure du déséquilibre correspondant à une moyenne du premier signal crête, la deuxième mesure du déséquilibre correspondant à une moyenne du deuxième signal crête.

9. Procédé de réduction de la fuite provenant d'un mélangeur équilibré double (250) pour combiner un signal d'oscillateur local différentiel avec un signal radiofréquence différentiel afin de générer un signal de sortie différentiel comprenant les étapes consistant à :
- mesurer (230) un degré de déséquilibre associé au signal de sortie différentiel du mélangeur équilibré double (250), et ajuster (240) un point de polarisation de quatre dispositifs de commutation (T1A, T1B, T2A, T2B) du mélangeur équilibré double (250) par addition d'un signal de correction fondé sur le degré de déséquilibre, à l'oscillateur local grâce à des dispositifs de sommation (S1A, S1B, S2A, S2B).

10. Procédé selon la revendication 9, dans lequel le signal de sortie différentiel du mélangeur équilibré double (250) a une première phase et une deuxième phase, et la mesure (230) du degré de déséquilibre comprend : la mesure d'un déséquilibre associé à la première phase et la mesure d'un déséquilibre associé à la deuxième phase.

11. Procédé selon la revendication 10, dans lequel l'ajustement (240) du point de polarisation comprend l'ajustement d'un point de polarisation d'un ou plusieurs des premiers dispositifs de commutation (T1A, T2A) qui commandent la première phase, fondé sur le déséquilibre associé à la deuxième phase, et l'ajustement d'un point de polarisation d'un ou plusieurs des deuxièmes dispositifs de commutation (T1B, T2B) qui commandent la deuxième phase, fondé sur le déséquilibre associé à la première phase.

12. Procédé selon la revendication 10, dans lequel la mesure (230) du déséquilibre associé à la première phase et à la deuxième phase comprend la mesure des excursions de crête de la première phase et de la deuxième phase.

13. Procédé selon la revendication 9, dans lequel la mesure (230) du degré de déséquilibre comporte la mesure d'une excursion de crête du signal de sortie.
